# EUROPÄISCHE PATENTSCHRIFT

(11) **EP 1 279 004 B1**
(45) Veröffentlichungstag und Bekanntmachung des Hinweises auf die Patenterteilung: **16.03.2005**
(21) Anmeldenummer: 01936033.8
(22) Anmeldetag: 27.04.2001
(51) Int. Cl.: G01D 5/26, G01B 11/00, H01L 31/02

(54) **ABTASTEINHEIT FÜR EINE OPTISCHE POSITIONSMESSEINRICHTUNG**
SCANNING UNIT FOR AN OPTICAL POSITION MEASURING DEVICE
UNITE DE BALAYAGE POUR DISPOSITIF DE MESURE OPTIQUE DE LA POSITION

(30) Priorität: 28.04.2000 DE 10022619
(43) Veröffentlichungstag der Anmeldung: 29.01.2003
(60) Teilanmeldung: 04027488.8
(73) Patentinhaber: Dr. Johannes Heidenhain GmbH, 83301 Traunreut (DE)
(72) Erfinder: MAYER, Elmar, J., 83365 Nussdorf (DE); HOLZAPFEL, Wolfgang, 83119 Obing (DE); LOESCHCKE, Klaus, 12527 Berlin (DE)
(86) Internationale Anmeldenummer: PCT/DE2001/001672
(87) Internationale Veröffentlichungsnummer: WO 2001/084083

(56) Entgegenhaltungen:
- US-A- 4 652 693
- PATENT ABSTRACTS OF JAPAN vol. 009, no. 329 (P-416), 24. Dezember 1985 (1985-12-24) -& JP 60 154112 A (SANKUSU KK), 13. August 1985 (1985-08-13)

## Beschreibung

Die Erfindung bezieht sich auf eine Abtasteinheit für eine optische Positionsmesseinrichtung mit einem strukturierten optoelektronischen Fotodetektor gemäß dem Oberbegriff der Patentansprüche 1 und 2.

Aus der WO 99/08074 ist eine Abtasteinheit für eine optische Positionsmeßeinrichtung bekannt, die neben periodischen Inkrementalsignalen auch mindestens ein Referenzimpulssignal bei einer definierten Referenzposition eines Maßstabes und einer relativ dazu beweglichen Abtasteinheit liefert. Auf den Maßstab ist mindestens ein Referenzmarkierungsfeld in einer Inkrementalteilungsspur integriert angeordnet und die Abtasteinheit umfaßt eine Detektoranordnung, die in Meßrichtung mindestens drei benachbart angeordnete, aktive Detektorbereiche aufweist. Zwei der drei Detektorbereiche bilden Referenzimpulssignal-Detektorbereiche und dienen zur Erzeugung eines Referenzimpulssignales, wobei die Relativanordnung der Referenzimpulssignal-Detektorbereiche in Meßrichtung in Abhängigkeit von der Strukturierung des Referenzmarkierungsfeldes auf den Maßstab gewählt ist. Ein zwischen den Referenzimpulssignal-Detektorbereichen angeordneter Detektorbereich dient zur Erzeugung mindestens eines Inkrementalsignales.

Wie insbesondere der Figur 3a dieser Druckschrift mit einer Anordnung aktiver Detektorbereiche sowohl für Referenzimpulssignal-Detektorbereiche als auch für Inkrementalsignal-Detektorbereiche zu entnehmen ist, erfolgt die Kontaktierung der verschiedenen aktiven Detektorbereiche an den Stirnseiten der Detektorbereiche und infolge der zahlreichen parallelen Leitungsführungen benötigt die Anordnung seitlich der Detektorbereiche viel Platz auf der Platine bzw. dem Halbleitersubstrat des Fotodetektors, auf dem die aktiven Detektorbereiche und die Kontaktierungs-Leiterbahnen anzuordnen sind. Dieser seitlich der aktiven Detektorbereiche benötigte Platz für die Leiterbahnen kann daher nicht für die aktiven Detektorbereiche auf dem Halbleitersubstrat zur Aufnahme der Detektorbereiche und Leiterbahnen verwendet werden.

Zur Erzeugung der Inkremental- und Referenzimpulssignale ist es jedoch von besonderer Bedeutung, die strahlungsempfindlichen Detektorbereiche des Fotodetektors möglichst großflächig zu machen, um auf der Empfangsseite der Abtasteinheit möglichst viel im Durchlicht- oder Auflichtverfahren empfangenes Licht einzukoppeln. Dem steht allerdings die Miniaturisierung der optischen Positionsmeßeinrichtung entgegen, bei der die Abtasteinheit ein möglichst kleines Volumen beanspruchen soll, was dazu führt, daß für die Detektorbereiche auf dem Substrat eine nur geringe Fläche zur Verfügung steht. Auf dieser Fläche müssen bei einer Relativ- und Absolutmessung sowohl die Inkrementalsignal-Detektorbereiche als auch die Referenzimpuls-Detektorbereiche so angeordnet werden, daß auch unter ungünstigen Bedingungen wie starken Verschmutzungen eine einwandfreie Erfassung und Abgabe von Inkremental- und Referenzimpulssignalen gewährleistet ist.

Aus der JP 60 154 112 A ist ein fotoelektrischer Wandler zur Positionserfassung bekannt, der auf einem n-leitenden Halbleitersubstrat vier strahlungsempfindliche, radial zueinander und getrennt voneinander angeordnete p-leitende Halbleiterbereiche aufweist. Um mögliche Unterschiede der Sensorcharakteristiken zu vermindern, sind die vier strahlungsempfindlichen Halbleiterbereiche viertelkreisförmig radial zueinander und durch schmale Isolationsstege voneinander getrennt gedrängt zueinander angeordnet. Die die fotoempfindlichen Halbleiterbereiche aufweisende Seite des fotoelektrischen Wandlers ist mit einem transparenten Isolationsfilm abgedeckt. Auf den Oberflächen der fotoempfindlichen Halbleiterbereiche sind anodenseitige Elektroden vorgesehen und mit den fotoempfindlichen Halbleiterbereichen über ohmsche, den transparenten Isolationsfilm durchdringende Leitungen verbunden. Das n-leitende Halbleitersubstrat dient als gemeinsame Katode der fotoempfindlichen Halbleiterbereiche. Die anodenseitigen Verbindungen der fotoempfindlichen Halbleiterbereiche gehen über den Rand der fotoempfindlichen Halbleiterbereiche hinausn und nutzen die Eckbereiche des quadratischen fotoelektrischen Wandlers mit den darin einen Vollkreis bildenden viertelkreisförmigen fotoelektrischen Halbleiterbereichen.

Aus der US-A-4 652 693 ist ein Photovoltaik-Modul mit mehreren streifenförmigen Photovoltaik-Zellen bekannt, die schichtförmig aufeinander angeordnet eine elektrisch leitfähige Substratschicht, einen Halbleiterkörper und eine transparente elektrisch leitfähige Schicht aufweisen. Jede Photovoltaik-Zelle enthält weiterhin ein vorgeformtes Dünnfilmgitter und eine Verbindungsstruktur, die mit der transparenten elektrisch leitfähigen Schicht verbunden sind, die streifenförmigen Photovoltaik-Zellen in Reihenschaltung elektrisch miteinander verbinden und den photovoltaisch gewonnenen Strom einer Sammelschiene zuführen, die die gewonnene photovoltaische Energie bereitstellt.

Der vorliegenden Erfindung liegt die Aufgabenstellung einer optimalen Nutzung der verfügbaren Fläche zugrunde, die für die Detektorbereiche auf dem Substrat eines Fotodetektors einer Abtasteinheit mit einem strukturierten optoelektronischen Fotodetektor zur Verfügung steht, der aus schmalen, rechteck- oder kreisabschnittsförmigen, strahlungsempfindlichen Streifen besteht, deren Längsseiten im wesentlichen senkrecht zur Messrichtung benachbart zueinander angeordnet sind.

Diese Aufgabe wird erfindungsgemäß durch die Merkmale der Patentansprüche 1 und 2 gelöst.

Die erfindungsgemäße Lösung ermöglicht die optimale Nutzung der für die Detektorbereiche auf dem Substrat eines Fotodetektors einer Abtasteinheit verfügbaren Fläche zur Erzeugung von Inkrementalsignalen und ggf. Referenzimpulssignalen, indem die gesamte Substrat- oder Platinenfläche, insbesondere die quer zur Meßrichtung verlaufende Breite des Substrats vollständig für die Detektorbereiche genutzt werden kann, da die zu den einzelnen Detektorbereichen führenden Leiterbahnen über die Oberfläche der Detektorbereiche geführt und mit den jeweiligen Detektorbereichen verbunden sind. Die optimale Ausnutzung der teuren (Silizium-) Halbleiter-Substratfläche trägt nicht nur einer Minimierung des Fotodetektors Rechnung, sondern reduziert auch die Herstellungskosten.

Die erfindungsgemäße Lösung weist den besondere Vorteil auf, daß zur Erzeugung der Abtastsignale die Längserstrekkung der Detektorbereiche quer zur Meßrichtung maximal ist, so daß auch unter ungünstigen Bedingungen noch hinreichend Licht eingekoppelt wird.

Eine Weiterbildung der erfindungsgemäßen Lösung ist dadurch gekennzeichnet, dass die Detektorbereiche periodisch und äquidistant zueinander angeordnet sind, wobei mehrere benachbarte Detektorbereiche eine Gruppe bilden, die zueinander phasenversetzte Abtastsignale liefert, und dass jeweils eine Leiterbahn mit den Detektorbereichen der verschiedenen Gruppen verbunden ist, die phasengleiche Abtastsignale abgeben.

Über die gruppenweise zusammengefassten Detektorbereiche ist eine sogenannte "Einfeldabtastung" des Massstabes gewährleistet, bei der sämtliche Signalanteile zur Erzeugung der Abtastsignale stets nur aus einer Teilungsperiode des abgetasteten Massstabes stammen. Eine derartige Anordnung ist insbesondere hinsichtlich der Unempfindlichkeit gegenüber Verschmutzungen des Massstabes vorteilhaft, da die phasenverschobenen Signalanteile, die zur Erzeugung der Abtastsignale beitragen, allesamt gleich beeinflusst werden.

Vorzugsweise bilden jeweils vier aktive Detektorbereiche eine Gruppe, die vier jeweils um 90° phasenversetzte Abtastsignale liefert, wobei mindestens zwei Gruppen aktiver Detektorbereiche in Messrichtung nebeneinander angeordnet und vier parallele Leiterbahnen mit den Detektorbereichen der Gruppen verbunden sind, die phasengleiche Abtastsignale abgeben.

Des weiteren können vorteilhaft mehrere Gruppen aktiver Detektorbereiche in Messrichtung hintereinander und nebeneinander angeordnet werden, wobei eine dem Phasenversatz entsprechende Anzahl Leiterbahnen mit den Detektorbereichen der in Messrichtung hintereinander angeordneten Gruppen verbunden ist, die phasengleiche Abtastsignale liefern. Die phasengleiche Abtastsignale erfassenden Leiterbahnen der in Messrichtung parallel zueinander angeordneten Gruppen sind dabei miteinander verbunden.

Die Verbindung der phasengleichen Abtastsignale erfassenden Leiterbahnen der in Messrichtung parallel zueinander angeordneten Gruppen kann insbesondere auf der Rückseite des strukturierten Fotodetektors angeordnet werden.

Für den Betrieb einer derartigen Abtasteinheit weist der strukturierte Fotodetektor in Messrichtung vorzugsweise mehrere hintereinander angeordnete Gruppen mit jeweils mehreren Detektorbereichen auf, wobei der eine Teil der Gruppen Referenzimpuls-Detektorbereiche zur Erzeugung von Referenzimpuls-Signalen und der andere Teil der Gruppen Inkrementalsignal-Detektorbereiche zur Erzeugung von Inkrementalsignalen enthält. Die Referenzimpuls-Detektorbereiche sind mit Referenzimpuls-Leiterbahnen und die Inkrementalsignal-Detektorbereiche, die phasengleiche Ausgangssignale liefern, sind mit jeweils einer Inkrementalsignal-Leiterbahn verbunden.

Eine vorteilhafte Weiterbildung der erfindungsgemäßen Lösung ist dadurch gekennzeichnet, dass zumindest die Inkrementalsignal-Leiterbahnen über die strahlungsempfindlichen Oberflächen der Inkrementalsignal-Detektorbereiche geführt und jeweils mit phasengleiche Ausgangssignale liefernden Inkrementalsignal-Detektorbereichen verbunden sind.

Weiterhin können zwei Gruppen Inkrementalsignal-Detektorbereiche mit jeweils zwei in Messrichtung hintereinander und nebeneinander angeordneten Gruppen von phasengleiche Ausgangssignale liefernden Detektorbereichen und eine zwischen den beiden Gruppen von Inkrementalsignal-Detektorbereichen eine Gruppe von Referenzimpuls-Detektorbereichen vorgesehen werden, während die Inkrementalsignal-Leiterbahnen jeweils zu den Stirnseiten des strukturierten Fotodetektors geführt sind. Dabei können die Referenzimpuls-Leiterbahnen zwischen den in Messrichtung nebeneinander angeordneten Gruppen von Inkrementalsignal-Detektorbereichen angeordnet werden.

Zur Erzeugung der Referenzimpulssignale können die die Taktsignale der Referenzimpuls-Detektorbereiche erfassenden Referenzimpuls-Leiterbahnen zu der einen Stirnseite zwischen den in Messrichtung nebeneinander angeordneten Gruppen von Imkrementalsignal-Detektorbereichen dieser Seite und die die Gegentaktsignale der Referenzimpuls-Detektorbereiche erfassenden Referenzimpuls-Leiterbahnen zu der anderen Stirnseite zwischen den in Messrichtung nebeneinander angeordneten Gruppen von Inkrementalsignal-Detektorbereichen dieser Seite geführt werden.

Alternativ können die die Taktsignale und die die Gegentaktsignale der Referenzimpuls-Detektorbereiche erfassenden Referenzimpuls-Leiterbahnen abschnittsweise übereinander angeordnet zwischen den in Messrichtung nebeneinander angeordneten Gruppen von Inkrementalsignal- Detektorbereichen der einen Seite geführt werden.

Da die Leiterbahnen mit einer Isolationsschicht zumindest auf der den Detektorbereichen zugewandten Seite versehen sind, können die Referenzimpuls-Leiterbahnen zumindest teilweise über die einander gegenüberliegenden Seitenränder der in Messrichtung nebeneinander angeordneten Gruppen der Inkrementalsignal-Detektorbereiche geführt werden.

Schließlich können die in Messrichtung jeweils hintereinanderliegenden Gruppen von Inkrementalsignal-Detektorbereichen mit jeweils einer Inkrementalsignal-Leiterbahn für phasengleiche Ausgangssignale verbunden und die Inkrementalsignal-Leiterbahnen über die Referenzimpuls-Detektorbereiche geführt werden.

Anhand von in der Zeichnung dargestellten Ausführungsbeispielen soll der der Erfindung zugrunde liegende Gedanke näher erläutert werden. Es zeigen:
- Fig. 1 bis 3 -: eine optische Positionsmeßeinrichtung mit Abtasteinheit und Maßstab sowie eine vergrößerte Draufsicht auf eine Platine und eine Abtastplatte der Abtasteinheit;
- Fig. 4 -: eine schematische Darstellung mehrerer hintereinander und nebeneinander angeordneter Gruppen von Detektorbereichen zur Erzeugung von Inkrementalsignalen mit Leiterbahnen, die Detektorbereiche mit phasengleichen Abtastsignalen kontaktieren;
- Fig. 5 -: eine schematische Darstellung von neben- und hintereinander angeordneten Gruppen von Inkrementalsignal- und Referenzimpuls-Detektorbereichen sowie Leiterbahnen, die phasen- und taktgleiche Abtastsignale liefernde Detektorbereiche zusammenfassen und
- Fig. 6 -: eine schematisch-perspektivische Darstellung eines Fotodetektors mit einer phasengleiche Abtastsignale abgebende Detektorbereiche zusammenfassende und über die Detektorbereiche gelegten Leiterbahn.

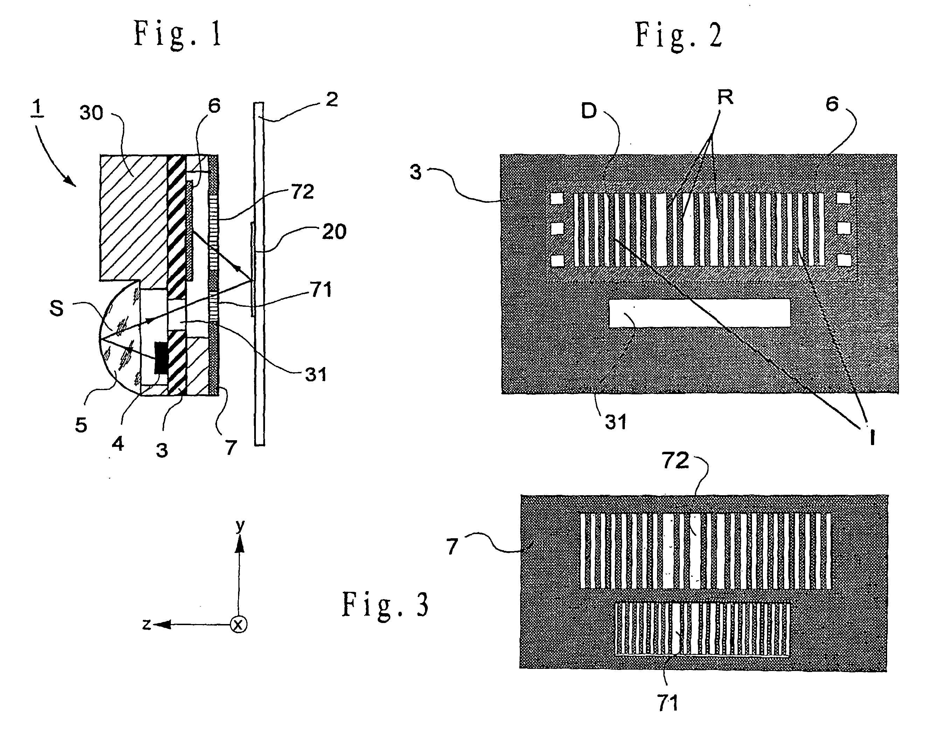

Figur 1 zeigt einen Querschnitt durch eine optische Positionsmesseinrichtung, die eine Abtasteinheit 1 und einen relativ zur Abtasteinheit 1 in Messrichtung x beweglichen Maßstab 2 enthält. Die Abtasteinheit 1 umfasst einen sendeseitigen Teil, der eine Lichtquelle 4, die auf einer in Draufsicht in Figur 2 dargestellten Platine 3, vorzugsweise in Form einer auf der Oberfläche der Platine 3 befestigten lichtemittierenden Diode ausgebildet ist, und eine der Lichtquelle 4 zugeordnete Kollimatoroptik 5 in Form einer Zylinderlinse, die mit ihrer ebenen Fläche der Lichtquelle 4 zugewandt auf einem mit der Platine 3 verbundenen Aufbau 30 befestigt ist.

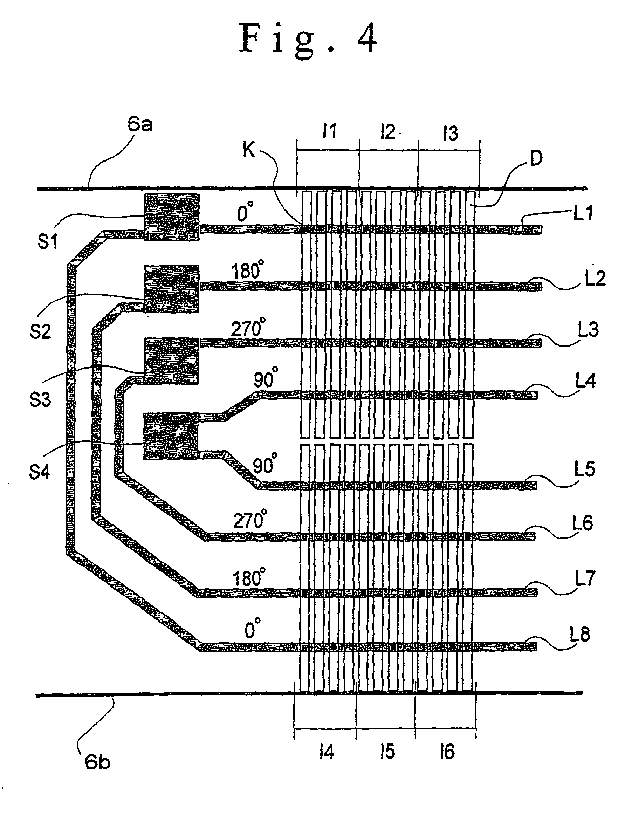

Im empfangsseitigen Teil der Abtasteinheit 1 ist auf der Platine 3 ein Fotodetektor oder Fotosensor 6 mit verschiedenen aktiven, strahlungsempfindlichen Detektorbereichen D (Figur 2) vorgesehen, zwischen denen jeweils inaktive, strahlungsunempfindliche Bereiche angeordnet sind. In geringem Abstand zur Platine 3 ist eine in Figur 3 in Draufsicht dargestellte Abtastplatte 7 angeordnet, die in Messrichtung x nebeneinander angeordnet eine Sendestruktur 71 und eine Abtaststruktur 72 enthält.

Beabstandet zur Abtasteinheit 1 ist der Maßstab 2 angeordnet, der eine sich in Messrichtung x erstreckende Messteilung 20 enthält, deren optische Abtastung bei der Relativbewegung zwischen Abtasteinheit 1 und Maßstab 2 Abtastsignale liefert. Der in Figur 1 schematisch dargestellte Strahlengang S geht von der Lichtquelle 4 aus und wird mittels der Zylinderlinse 5 durch eine in der Platine 3 vorgesehene, sich in Messrichtung x erstreckende Öffnung 31 zur Abtastplatte 7 und der darauf angeordneten Sendestruktur 71 reflektiert und gelangt durch die Sendestruktur 71 zu der auf dem Maßstab 2 angeordneten Meßteilung 20, von der der Messstrahl S durch die Abtaststruktur 72 zu dem vorzugsweise auf einem Halbleitersubstrat angeordneten Fotodetektor 6 mit den darauf vorgesehenen strahlungsempfindlichen Detektorbereichen D reflektiert wird.

Die in Figur 1 dargestellte optische Positionsmesseinrichtung arbeitet im Auflicht, so dass die auf dem Maßstab 2 vorgesehene Messteilung reflektierende und nichtreflektierende Teilbereiche aufweist, die den Strahlengang S reflektieren bzw. nicht reflektieren. Bei einer im Durchlicht arbeitenden optischen Positionsmesseinrichtung befindet sich der Maßstab 2 zwischen dem sendeseitigen. Teil der Abtasteinheit 1 und deren empfangsseitigem Teil, so dass der von der Lichtquelle 4 ausgehende Strahlengang über die Zylinderlinse 5 und die Sendestruktur 71 der Abtastplatte zur Messteilung 20 des Maßstabes 2 und durch die Messteilung 20 hindurch über die Sendestruktur 71 zum Fotodetektor 6 der Abtasteinheit 1 gelangt. In diesem Falle sind die auf dem Maßstab 2 vorgesehenen Abtastfelder der Messteilung 20 für die verwendete Lichtwellenlänge durchlässig und nicht-durchlässig ausgebildet.

Um bei einer oder mehreren definierten Relativpositionen der zueinander beweglichen Teile der optischen Positionsmeßeinrichtung einen exakten Absolutbezug der Positionsmessung herzustellen, werden neben den Inkrementalsignalen bezüglich des Relativversatzes auch sogenannte Referenzimpulssignale benötigt, zu deren Erzeugung auf Seiten des Maßstabes der jeweiligen Positionsmeßeinrichtung an einer oder mehreren Positionen Referenzmarkierungsfelder angeordnet sind. Die Abtasteinheit einer derartigen Positionsmeßeinrichtung bietet damit die Möglichkeit, bei der zu detektierenden Relativposition von Maßstab und Abtasteinheit ein entsprechendes Referenzimpulssignal zu erzeugen, das in der nachgeordneten Auswerteeinrichtung geeignet verarbeitet wird.

Zur Erfassung der Relativ- und Absolutposition von Abtasteinheit und Maßstab, die beispielsweise in Werkzeugmaschinen zur Erfassung der relativen und absoluten Position von Werkstück und Werkzeug eingesetzt werden, sind daher entsprechende Referenzmarkierungsfelder auf dem Maßstab und Referenzimpuls-Detektorbereiche R sowie Inkrementalsignal-Detektorbereiche I als Detektorbereiche D auf dem Substrat 3 des Fotodetektors 6 vorgesehen.

Weitere Einzelheiten zur Aufgabe, Funktion und Gestaltung der Inkrementalteilungsspur und der Referenzmarkierungsfelder auf dem Maßstab sowie der Inkrementalsignal-Detektorbereiche und Referenzimpuls-Detektorbereiche des Fotodetektors zur Erzeugung von Inkremental- und Referenzimpulssignalen sind der vorstehend genannten WO 99/08074 zu entnehmen. Zur Detektion der vom Maßstab 2 kommenden Strahlenbündel ist in den Ausführungsbeispielen der Figuren 4 bis 6 eine strukturierte Detektoranordnung vorgesehen, die aus mehreren aktiven, d.h. strahlungsempfindlichen Detektorbereichen besteht, die jeweils eine schmale Streifenform aufweisen und in Meßrichtung x periodisch und benachbart zueinander angeordnet sind. Hierzu wird ein geeignetes Halbleitersubstrat derart strukturiert, daß auf dem Substrat eine Reihe strahlungsempfindlicher Detektorbereiche resultiert. Die verschiedenen aktiven Detektorbereiche liefern im Fall der Relativbewegung von Maßstab und Abtasteinheit jeweils Signalanteile, die zur Erzeugung phasenversetzter Inkrementalsignale herangezogen werden.

Die in Figur 4 schematisch dargestellte Draufsicht auf einen Fotodetektor zeigt mehrere Gruppen hintereinander und nebeneinander angeordneter Detektorbereiche I1 bis I6 zur Erfassung von Abtastsignalen, die als Inkrementalsignale einer Auswerteeinrichtung zugeführt werden. Vier Inkrementalsignal-Detektorbereiche bilden dabei jeweils eine Gruppe I1 bis I6, wobei jeweils ein Inkrementalsignal-Detektorbereich ein Teil-Inkrementalsignal mit der Phasenlage 0°, ein Inkrementalsignal-Detektorbereich ein Teil-Inkrementalsignal mit der Phasenlage 180°, ein Inkrementalsignal-Detektorbereich ein Teil-Inkrementalsignal mit der Phasenlage 90° und ein Inkrementalsignal-Detektorbereich ein Teil-Inkrementalsignal mit der Phasenlage 270° liefert.

Selbstverständlich kann auch eine andere Relativanordnung der verschiedenen Inkrementalsignal-Detektorbereiche gewählt werden, so daß diese dann Teil-Inkrementalsignale mit anderen relativen Phasenlagen als in dem in Figur 4 dargestellten Beispiel liefern. Beispielsweise wäre eine Anordnung der Inkrementalsignal-Detektorbereiche möglich, die Signale mit der Phasenlage 0°, 120°, 240°... liefern. Referenzimpulsignal-Detektorbereiche weist diese Anordnung nicht auf.

Die im Beispiel von Figur 4 gezeigte Anordnung der aktiven Detektorbereiche hat zur Folge, daß die innerhalb einer Teilungsperiode liegenden, benachbarten aktiven Detektorbereiche einer Vierergruppe I1 bis I6 bei der optischen Abtastung der Inkrementalteilung vier jeweils um 90° phasenversetzte Abtastsignale liefern. Über die gezeigte Anordnung der Detektorbereiche ist somit eine sogenannte "Einfeldabtastung" des Maßstabes gewährleistet, bei der sämtliche Signalanteile zur Erzeugung der Inkrementalsignale stets nur aus einer Teilungsperiode des abgetasteten Maßstabes stammen. Eine derartige Abtastung ist insbesondere hinsichtlich der Unempfindlichkeit gegenüber großflächigen Verschmutzungen des Maßstabes vorteilhaft, da die phasenverschobenen Signalanteile, die zur Erzeugung der Abtastsignale beitragen, allesamt gleich beeinflußt werden.

In Figur 4 sind schematisch die Seitenränder 6a, 6b der aktiven Fläche des Fotodetektors 6 gemäß Figur 1 dargestellt, die die Seitenränder des Halbleitersubstrats bilden, auf dem die strahlungsempfindlichen Detektorbereiche strukturiert ausgebildet sind. Üblicherweise wird die Länge der aktiven Detektorbereiche senkrecht zur Meßrichtung x dadurch begrenzt, daß die mit den Detektorbereichen verbundenen Leiterbahnen zwischen den Stirnseiten der Detektorbereiche und den Seitenrändern 6a, 6b geführt werden bzw. von den Stirnseiten der Detektorbereiche über die Seitenkanten zur Platine bzw. zur Rückseite des Halbleitersubstrats geführt werden müssen.

Demgegenüber werden in der erfindungsgemäßen Ausführungsform die Leiterbahnen L1 bis L8 quer zur Längserstreckung der Detektorbereiche D über die Oberflächen der Detektorbereiche D geführt. Dabei weisen die Leiterbahnen L1 bis L8 zumindest auf der der Oberseite der Detektorbereiche D zugewandten Seite eine Isolation auf, die nur an vorgegebenen Punkten K zur Kontaktierung mit vorgegebenen Detektorbereichen durchbrochen wird. Auf diese Weise werden phasengleiche Abtastsignale liefernde Detektorbereiche D der einzelnen Gruppen I1 bis I6 zusammengefaßt und über Kontakte S1 bis S4 zur Signalverarbeitung an die Auswerteeinrichtung weitergeleitet.

Das in Figur 4 dargestellte Ausführungsbeispiel zeigt die zusammenfassung von vier, jeweils um 90° phasenversetzte Abtastsignale, die aus der Verbindung der Leiterbahnen L1 bis L8 mit den jeweiligen Detektorbereichen D der hinterund nebeneinander angeordneten Gruppen von Detektorbereichen I1 bis I6 resultieren.

Wie der Darstellung gemäß Figur 4 zu entnehmen ist, bewirkt die Führung der Leiterbahnen L1 bis L8 quer über die Längserstreckungen der Detektorbereiche D eine optimale Ausnutzung der zur Verfügung stehenden Fläche des Fotodetektors, indem die Detektorbereiche D bis unmittelbar an die Seitenränder 6a, 6b des Fotodetektors geführt werden können.

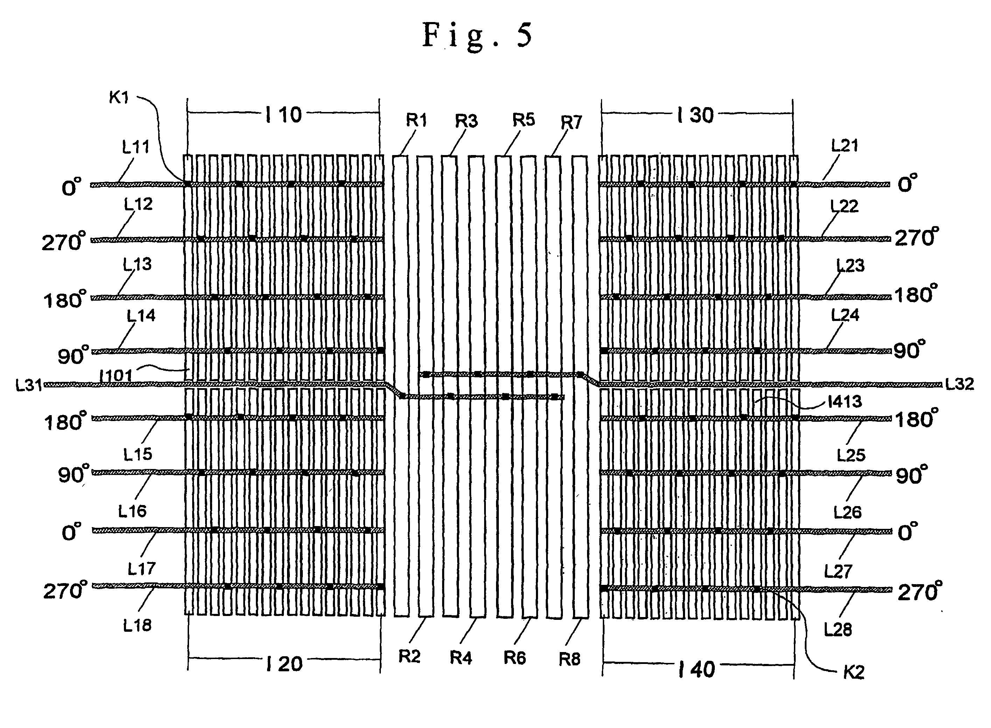

Eine andere Form einer strukturierten Detektoranordnung ist in Figur 5 als Draufsicht auf beispielsweise ein Halbleitersubstrat dargestellt, das die aktiven Detektorbereiche neben den inaktiven Bereichen ausbildet. In dieser Ausführungsform sind sowohl Inkrementalsignale als auch Referenzimpulssignale als Abtastsignale liefernde Detektorbereiche vorgesehen, so daß diese Anordnung geeignet ist, sowohl die relative Stellung zweier relativ zueinander bewegter Systeme als auch eine absolute Position der relativ zueinander bewegten Systeme zu erfassen.

Die Inkrementalsignale werden in zwei Inkrementalsignal-Detektorbereichen erfaßt, die durch einen Referenzimpulssignal-Detektorbereich voneinander getrennt sind. Die Inkrementalsignal-Detektorbereiche I10, I20; I30 und I40 werden durch gruppenweise zusammengefaßte Teilbereiche gebildet, die in Meßrichtung x hintereinander angeordnet sind. Jeweils phasengleiche Abtastsignale liefernde Detektorbereiche werden mittels quer über die Längserstreckung der Detektorbereiche und damit in Meßrichtung x verlaufender Leiterbahnen L11 bis L28 kontaktiert.

Die Inkrementalsignal-Detektorbereiche I10, I20, I30, I40 liefern jeweils um 90° phasenversetzte Inkrementalsignale und sind dementsprechend über die Leiterbahnen L11 bis L28 durch entsprechende Kontaktpunkte mit den entsprechenden Detektorbereichen zusammengefaßt. So liefern beispielsweise die Leiterbahnen L11, L17, L21 und L27 die Phasenlagen 0°, während die Leiterbahnen L12, L18, L22 und L28 die um 90° phasenversetzten Phasenlagen von 270° über jeweils vier hintereinander angeordnete Detektorgruppen eines Detektorbereichs liefern. Dabei erfaßt beispielsweise die Leiterbahn L11 am Kontaktpunkt K1 den Detektorbereich I101, während die Leiterbahn L28 am Kontaktpunkt K2 den Detektorbereich I413 erfaßt usw.

Der zwischen den Inkrementalsignal-Detektorbereichen I10, I20, I30, I40 angeordnete Referenzimpulssignal-Detektorbereich weist mehrere in Meßrichtung hintereinander angeordnete identische Referenzimpuls-Detektorbereiche R1 bis R8 auf, die im Unterschied zu den gruppenweise nebeneinander angeordneten Inkrementalsignal-Detektorbereichen durchgehend von der einen zur anderen Seitenkante der Detektoranordnung ausgebildet sind. Zur Erzeugung der Referenzimpulssignale werden die Referenzimpuls-Detektorbereiche R1 bis R8 mit einer Takt- und Gegentaktleitung L31, L32 kontaktiert, wobei jeweils ein Detektorbereich R1 bis R8 übersprungen wird, so daß jeder zweite Detektorbereich R1 bis R8 entweder mit der Taktleitung L31 oder der Gegentaktleitung L32 verbunden ist.

Analog zur Anordnung der Leiterbahnen gemäß Figur 4 sind auch bei dem in Figur 5 dargestellten Ausführungsbeispiel die Leiterbahnen L11 bis L28 quer über die Detektorbereiche der Inkrementalsignal-Detektorbereiche I10, I20, I30, I40 zu den Stirnseiten der Detektoranordnung geführt. Da die Leiterbahnen L11 bis L28 eine insgesamt geringe strahlungsempfindliche Fläche bei der Querung der Detektorbereiche belegen, kann abweichend von der in Fig. 5 dargestellten Konfiguration auch jeweils eine einzelne Leiterbahn über sämtliche (Inkrementalsignal- und Referenzimpuls-) Detektorbereiche geführt werden, um die phasenversetzten Abtastsignale von 0°, 270°, 180° und 90° der in Meßrichtung hintereinander angeordneten Gruppen durch Kontaktgabe mit den entsprechenden Inkrementalsignal-Detektorbereichen zu erfassen. Dies bedingt zwar eine Führung der Leiterbahnen über die Referenzimpuls-Detektorbereiche R1 bis R8 hinüber, würde aber aufgrund der großflächigen Referenzimpuls-Detektorbereiche eine nur geringfügige Beeinträchtigung der Referenzimpuls-Detektorbereiche bedeuten.

Die Takt- und Gegentaktleitung L31, L32 für die Referenzimpuls-Detektorbereiche R1 bis R8 ist in dem in Figur 5 dargestellten Ausführungsbeispiel zwischen die in Meßrichtung x nebeneinander liegenden Inkrementalsignal-Detektorbereiche I10, I20 bzw. I30, I40 hindurchgeführt. Diese Konfiguration nutzt den ohnehin für die Trennung der nebeneinander angeordneten Inkrementalsignal-Detektorbereiche I10, I20 bzw. I30, I40 erforderlichen Spalt aus, so daß keine aktive, d.h. strahlungsempfindliche Fläche beansprucht wird. Durch die Anordnung der Takt- und Gegentaktleitung L31, L32 zwischen den nebeneinander angeordneten Inkrementalsignal-Detektorbereichen I10, I20 sowie I30, I40 ist es möglich, die Stirnseiten sowohl der Inkrementalsignal-Detektorbereiche I10, I20, I30, I40 als auch der Referenzimpuls-Detektorbereiche R1 bis R8 bis unmittelbar an die Seitenkanten der Detektoranordnung zu führen und somit eine maximale aktive, d.h. strahlungsempfindliche Fläche für die Detektorbereiche vorzusehen.

Je nach Konfiguration und Baugröße des Fotodetektors sind aber auch abweichend von den Darstellungen in den Figuren 4 und 5 unterschiedliche Führungen der Leiterbahnen möglich. So kann beispielsweise die Takt- und Gegentaktleitung L31, L32 in der Anordnung gemäß Figur 5 auch an einer Seitenkante der Detektoranordnung entlang geführt werden. Dies schränkt allerdings die Möglichkeit ein, die Stirnseiten sowohl der Inkrementalsignal-Detektorbereiche als auch der Referenzimpuls-Detektorbereiche bis unmittelbar an die Seitenkanten der Detektoranordnung zu führen.

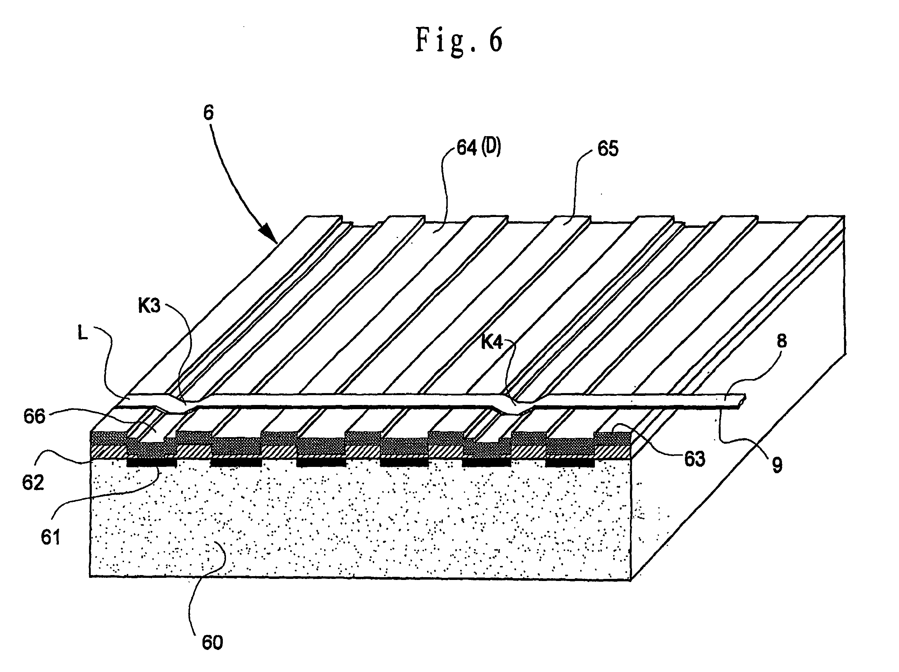

Figur 6 zeigt eine schematisch-perspektivische Ansicht eines optoelektronischen Fotodetektors bzw. Fotosensors mit einer über die Oberfläche des Fotodetektors 6 geführten Leiterbahn L, die an zwei Kontaktierungsstellen K3, K4 mit aktiven, d.h. strahlungsempfindlichen Detektorbereichen des Fotodetektors 6 verbunden ist.

Der halbleitende Grundkörper des optoelektronischen Fotodetektors 6 besteht beispielsweise aus Silizium und umfaßt eine breite n-leitende Schicht 60 (300 µm bis 400 µm dick), an deren Oberfläche sich mehrere äquidistant verteilt angeordnete, wesentlich dünnere p-leitende Schichten 61 (ca. 0,55 *µ*m dick) erstrecken. Zwischen der n-leitenden Schicht 60 und den p-leitenden Schichten 61 bilden sich Raumladungszone (Verarmungszonen) aus, die als Sperrschichten wirken.

Die Vorderseite des optoelektronischen Fotodetektors 6 ist mit einer metallischen Antireflexionsschicht 63 versehen und wird durch eine isolierende Schicht 62 strukturiert, die z. B. aus Siliziumdioxid als Isolator bestehen können. Zwischen den isolierenden oder inaktiven Bereichen 65 erstrecken sich so die aktiven, strahlungsempfindlichen Detektorbereiche 64 bzw. D.

Auf die aktiven, strahlungsempfindlichen Detektorbereiche 64 bzw. D auftreffende elektromagnetische Strahlung gelangt durch die p-leitenden Schichten 61 in die Raumladungszone und wird dort zu einem großen Teil absorbiert. Dabei entstehen in der Raumladungszone Elektron-Lochpaare. Das Raumladungsfeld trennt diese Trägerpaare; Elektronen fließen zur n-, Löcher zur p-Seite. Um diesen Fotostrom, der ein Maß für die einfallende Strahlungsleistung ist, messen zu können, wird der optoelektronische Photodetektor 6 in eine geeignete elektrische Schaltung integriert.

Die senkrecht zur Längserstreckung der aktiven Detektorbereiche 64 und über deren Oberfläche verlegte oder anderweitig aufgetragene Leiterbahn L besteht aus einem elektrisch leitfähigen Teil 8 sowie einer Isolationsschicht 9, die zumindest zwischen dem elektrisch leitfähigen Teil 8 und der Oberfläche des optoelektronischen Fotodetektors 6 vorgesehen ist. Die Isolationsschicht 9 bewirkt, daß nur an den gewünschten Stellen die Leiterbahn L die entsprechenden Detektorbereiche D des Fotodetektors 6 kontaktiert, um beispielsweise phasengleiche Abtastsignale zu erfassen und an eine Auswerteinrichtung weiterzuleiten.

An den Kontaktierungspunkten K3, K4, an denen die Leiterbahn L mit den entsprechenden Detektorbereichen 64 bzw. D des Fotodetektors 6 verbunden werden soll, ist eine Öffnung in der Antireflexionsschicht 63 vorgesehen bzw. wie in Figur 6 dargestellt, die Antireflexionsschicht 63 soweit an den Stellen 66 abgesenkt, daß sie unter Überbrückung der Isolationsschicht 62 die p-leitende Schicht 61 kontaktiert und dadurch die entsprechende Ladung zur Erzeugung eines Abtastsignals ausgekoppelt werden kann.

Die Verbindung der Leiterbahn L mit den entsprechenden Detektorbereichen 64 an den Kontaktpunkten K3, K4 kann durch entsprechendes Entfernen der Isolationsschicht 9 oder mittels Durchkontaktierung erfolgen. Beispielsweise kann der elektrisch leitende Teil 8 der Leiterbahn L an den Kontaktpunkten K3, K4 mittels eines Laserstrahls mit der Oberfläche der Antireflexionsschicht 63 bzw. abgesenkten Oberfläche 66 des betreffenden Detektorbereichs D leitfähig verbunden werden.

Die Erfindung beschränkt sich in ihrer Ausführung nicht auf die vorstehend angegebenen bevorzugten Ausführungsbeispiele, sondern es ist eine Anzahl von Varianten denkbar, welche von der in der Zeichnung und Beschreibung dargestellten Lösung auch bei grundsätzlich andersgearteten Ausführungen Gebrauch macht.

## Patentansprüche

1. Abtasteinheit für eine optische Positionsmesseinrichtung mit einem strukturierten optoelektronischen Fotodetektor (6), der mehrere benachbart zueinander auf einem gemeinsamen Halbleitersubstrat (60) eines ersten Leitfähigkeitstyps angeordnete Detektorbereiche (D; I1 - I6; I10, I11, I20, I21; R1 - R8), die aus schmalen, rechteck- oder kreisabschnittsförmigen, strahlungsempfindlichen Streifen eines zweiten Leitfähigkeitstyps (61) bestehen, deren Längsseiten im wesentlichen senkrecht zur Messrichtung (x) benachbart zueinander angeordnet sind und die über im wesentlichen senkrecht zu den Längsseiten der Detektorbereiche (D; I1 - I6; I10, I11, I20, I21; R1 - R8) geführte Leiterbahnen (L; L1 - L8; L11 - L28; L31, L32) mit einer Auswerteinrichtung verbunden sind, eine die Vorderseite des Fotodetektors (6) bildende Antireflexionsschicht (63) und eine dazwischen angeordnete Isolationsschicht (62) aufweist,
**dadurch gekennzeichnet,**
**dass** zumindest ein Teil der Leiterbahnen (L; L1 - L8; L11 - L28; L31, L32) über die Oberfläche mehrerer Detektorbereiche (D; I1 - I6; I10, I11, I20, I21; R1 - R8) geführt und mit den zugeordneten Detektorbereichen (D; I1 - I6; I10, I11, I20, I21; R1 - R8) verbunden ist, und dass an den Verbindungen der Leiterbahnen (L; L1 - L8; L11 - L28; L31, L32) mit den zugeordneten Detektorbereichen (D; I1 - I6; I10, I11, I20, I21; R1 - R8) Öffnungen in der Antireflexionsschicht (63) vorgesehen sind.

2. Abtasteinheit für eine optische Positionsmesseinrichtung mit einem strukturierten optoelektronischen Fotodetektor (6), der mehrere benachbart zueinander auf einem gemeinsamen Halbleitersubstrat (60) eines ersten Leitfähigkeitstyps angeordnete Detektorbereiche (D; I1 - I6; I10, I11, I20, I21; R1 - R8), die aus schmalen, rechteck- oder kreisabschnittsförmigen, strahlungsempfindlichen Streifen eines zweiten Leitfähigkeitstyps (61) bestehen, deren Längsseiten im wesentlichen senkrecht zur Messrichtung (x) benachbart zueinander angeordnet sind und die über im wesentlichen senkrecht zu den Längsseiten der Detektorbereiche (D; I1 - I6; I10, I11, I20, I21; R1 - R8) geführte Leiterbahnen (L; L1 - L8; L11 - L28; L31, L32) mit einer Auswerteinrichtung verbunden sind, eine die Vorderseite des Fotodetektors (6) bildende Antireflexionsschicht (63) und eine dazwischen angeordnete Isolationsschicht (62) aufweist,
**dadurch gekennzeichnet,**
**dass** zumindest ein Teil der Leiterbahnen (L; L1 - L8; L11 - L28; L31, L32) über die Oberfläche mehrerer Detektorbereiche (D; I1 - I6; I10, I11, I20, I21; R1 - R8) geführt und mit den zugeordneten Detektorbereichen (D; I1 - I6; I10, I11, I20, I21; R1 - R8) verbunden ist, und dass an den Verbindungen der Leiterbahnen (L; L1 - L8; L11 - L28; L31, L32) mit den zugeordneten Detektorbereichen (D; I1 - I6; I10, I11, I20, I21; R1 - R8) die Antireflexionsschicht (63) mit den dünnen, streifenförmigen Schichten (61) des zweiten Leitfähigkeitstyps verbunden ist.

3. Abtasteinheit nach Anspruch 1 oder 2, **dadurch gekennzeichnet, dass** die Detektorbereiche (D; I1 - I6; I10, I11, I20, I21; R1 - R8) periodisch zueinander angeordnet sind, wobei mehrere benachbarte Detektorbereiche eine Gruppe (I1 - I6; I10, I11, I20, I21; R1 - R8) bilden, die zueinander phasenversetzte Abtastsignale liefert, und dass jeweils eine Leiterbahn (L; L1 - L8; L11 - L28; L31, L32) mit den Detektorbereichen (D; I1 - I6; I10, I11, I20, I21; R1 - R8) der verschiedenen Gruppen verbunden ist, die phasengleiche Abtastsignale abgeben.

4. Abtasteinheit nach Anspruch 3, **dadurch gekennzeichnet, dass** vier aktive Detektorbereiche eine Gruppe (I1 - I6; I10, I11, I20, I21) bilden, die vier jeweils um 90° phasenversetzte Abtastsignale liefert, dass mindestens zwei Gruppen aktiver Detektorbereiche (I1 - I6; I10, I11, I20, I21) in Messrichtung (x) nebeneinander angeordnet sind und dass vier parallele Leiterbahnen (L1 - L8; L11 - L28) mit den Detektorbereichen der Gruppen (I1 - I6; I10, I11, I20, I21) verbunden sind, die phasengleiche Abtastsignale abgeben.

5. Abtasteinheit nach Anspruch 3 oder 4, **dadurch gekennzeichnet, dass** mehrere Gruppen aktiver Detektorbereiche (I1 - I6; I10, I11, I20, I21) in Messrichtung (x) hintereinander und nebeneinander angeordnet sind, dass eine dem Phasenversatz entsprechende Anzahl Leiterbahnen (L1 - L8; L11 - L28) mit den Detektorbereichen der in Messrichtung (x) hintereinander angeordneten Gruppen (I1 - I6; I10, I11, I20, I21) verbunden ist, die phasengleiche Abtastsignale liefern, und dass die phasengleiche Abtastsignale erfassenden Leiterbahnen (L1 - L8; L11 - L28) der in Messrichtung (x) parallel zueinander angeordneten Gruppen (I1 - I6; I10, I11, I20, I21;) miteinander verbunden sind.

6. Abtasteinheit nach Anspruch 5, **dadurch gekennzeichnet, dass** die Verbindung der phasengleiche Abtastsignale erfassenden Leiterbahnen (L1 - L8; L11 - L28) der in Messrichtung (x) parallel zueinander angeordneten Gruppen (I1 - I6; I10, I11, I20, I21) auf der Rückseite des strukturierten Fotodetektors (6) angeordnet ist.

7. Abtasteinheit nach mindestens einem der vorangehenden Ansprüche, **dadurch gekennzeichnet, dass** der strukturierte Fotodetektor (6) in Messrichtung (x) mehrere hintereinander angeordnete Gruppen (D; I1 - I6; I10, I11, I20, I21; R1 - R8) mit jeweils mehreren Detektorbereichen (D) aufweist, wobei der eine Teil der Gruppen Referenzimpuls-Detektorbereiche (R1 - R8) zur Erzeugung von Referenzimpuls-Signalen und der andere Teil der Gruppen Inkrementalsignal-Detektorbereiche (I1 - I6; I10, I11, I20, I21) zur Erzeugung von Inkrementalsignalen aufweist und dass die Referenzimpuls-Detektorbereiche (R1 - R8) mit Referenzimpuls-Leiterbahnen (L31, L32) und die Inkrementalsignal-Detektorbereiche (I1 - I6; I10, I11, I20, I21), die phasengleiche Ausgangssignale liefern, mit jeweils einer Inkrementalsignal-Leiterbahn (L1 - L8; L11 - L28) verbunden sind.

8. Abtasteinheit nach Anspruch 7, **dadurch gekennzeichnet, dass** zumindest die Inkrementalsignal-Leiterbahnen (L1 - L8; L11 - L28) über die strahlungsempfindlichen Oberflächen der Inkrementalsignal-Detektorbereiche (I1 - I6; I10, I11, I20, I21) geführt und jeweils mit phasengleiche Ausgangssignale liefernden Inkrementalsignal-Detektorbereichen (I1 - I6; I10, I11, I20, I21) verbunden sind.

9. Abtasteinheit nach Anspruch 7 oder 8, **dadurch gekennzeichnet, dass** zwei Gruppen Inkrementalsignal-Detektorbereiche (I10, I11, I20, I21) mit jeweils zwei in Messrichtung (x) hintereinander und nebeneinander angeordneten Gruppen von phasengleiche Ausgangssignale liefernden Detektorbereichen (I10, I11 bzw. I20, I21) und eine zwischen den beiden Gruppen von Inkrementalsignal-Detektorbereichen (I10, I11, I20, I21) eine Gruppe von Referenzimpuls-Detektorbereichen (R1 - R8) vorgesehen ist, und dass die Inkrementalsignal-Leiterbahnen (L11 - L28) jeweils zu den Stirnseiten des strukturierten Fotodetektors (6) geführt sind.

10. Abtasteinheit nach Anspruch 9, **dadurch gekennzeichnet, dass** die Referenzimpuls-Leiterbahnen (R1 - R8) zwischen die in Messrichtung nebeneinander angeordneten Gruppen von Inkrementalsignal-Detektorbereichen (I10, I11, I20, I21) geführt sind.

11. Abtasteinheit nach Anspruch 10, **dadurch gekennzeichnet, dass** die die Taktsignale der Referenzimpuls-Detektorbereiche (R1 - R8) erfassende Referenzimpuls-Leiterbahn (L31) zu der einen Stirnseite zwischen den in Messrichtung (x) nebeneinander angeordneten Gruppen von Imkrementalsignal-Detektorbereichen (I10, I11) dieser Seite und die die Gegentaktsignale der Referenzimpuls-Detektorbereiche (R1 - R8) erfassende Referenzimpuls-Leiterbahn (L32) zu der anderen Stirnseite zwischen den in Messrichtung (x) nebeneinander angeordneten Gruppen von Inkrementalsignal-Detektorbereichen (I20, I21) dieser Seite geführt sind.

12. Abtasteinheit nach Anspruch 10, **dadurch gekennzeichnet, dass** die die Taktsignale und die die Gegentaktsignale der Referenzimpuls-Detektorbereiche (R1 - R8) erfassenden Referenzimpuls-Leiterbahnen L31, L32) abschnittsweise übereinander angeordnet zwischen den in Messrichtung (x) nebeneinander angeordneten Gruppen von Inkrementalsignal-Detektorbereichen (I10, I11 bzw. I20, I21) der einen oder anderen Seite geführt sind.

13. Abtasteinheit nach Anspruch 9 oder 10, **dadurch gekennzeichnet, dass** die Referenzimpuls-Leiterbahnen (L31, L32) zumindest teilweise über die einander gegenüberliegenden Seiteriränder (6a, 6b) der in Messrichtung (x) nebeneinander angeordneten Gruppen der Inkrementalsignal-Detektorbereiche (I10, I11, I20, I21) geführt sind.

14. Abtasteinheit nach mindestens einem der vorangehenden Ansprüche 9 bis 11, **dadurch gekennzeichnet, dass** die in Messrichtung (x) jeweils hintereinanderliegenden Gruppen von Inkrementalsignal-Detektorbereichen (I10, I11, I20, I21) mit jeweils einer Inkrementalsignal-Leiterbahn (L11 - L28) für phasengleiche Ausgangssignale verbunden sind und dass die Inkrementalsignal-Leiterbahnen (L11 - L28) über die Referenzimpuls-Detektorbereiche (R1 - R8) geführt sind.

## Claims

1. Scanning unit for an optical position measuring device, having a structured optoelectronic photodetector (6), which has a plurality of detector regions (D; I1 - I6; I10, I11, I20, I21; R1 - R8), which are disposed adjacent to each other on a common semiconductor substrate (60) of a first conductivity type, said detector regions comprising narrow, rectangular or circular section-shaped, radiation-sensitive strips of a second conductivity type (61), the longitudinal sides of which are disposed adjacent to each other essentially perpendicularly to the measuring direction (x) and which are connected to an evaluation device via strip conductors (L; L1 - L8; L11 - L28; L31, L32), which are guided essentially perpendicularly to the longitudinal sides of the detector regions (D; I1 - I6; I10, I11, I20, I21; R1 - R8), an anti-reflection layer (63), which forms the front side of the photodetector (6) and an insulating layer (62) disposed therebetween,
**characterised in that**
at least one part of the strip conductors (L; L1 - L8; L11 - L28; L31, L32) is guided over the surface of a plurality of detector regions (D; I1 - I6; I10, I11, I20, I21; R1 - R 8) and is connected to the assigned detector regions (D; I1 - I6; I10, I11, I20, I21; R1 - R8), and **in that**, at the connections of the strip connectors (L; L1 - L8; L11 - L28; L31, L32) to the assigned detector regions (D; I1 - I6; I10, I11, I20, I21; R1 - R8), openings are provided in the anti-reflection layer (63).

2. Scanning unit for an optical position measuring device, having a structured optoelectronic photodetector (6), which has a plurality of detector regions (D; I1 - I6; no, I11, I20, I21; R1 - R8), which are disposed adjacent to each other on a common semiconductor substrate (60) of a first conductivity type, said detector regions comprising narrow, rectangular or circular section-shaped, radiation-sensitive strips of a second conductivity type (61), the longitudinal sides of which are disposed adjacent to each other essentially perpendicularly to the measuring direction (x) and which are connected to an evaluation device via strip conductors (L; L1 - L8; L11 - L28; L31, L32), which are guided essentially perpendicularly to the longitudinal sides of the detector regions (D; I1 - I6; I10, I11, I20, I21; R1 - R8), an anti-reflection layer (63), which forms the front side of the photodetector (6), and an insulating layer (62) disposed therebetween,
**characterised in that**
at least one part of the strip conductors (L; L1 - L8; L11 - L28; L31, L32) is guided over the surface of a plurality of detector regions (D; I1 - I6; I10, I11, I10, I21; R1 - R8) and is connected to the assigned detector regions (D; I1 - I6; I10, I11, I20, I21; R1 - R8), and **in that**, at the connections of the strip conductors (L; L1 - L8; L11 - L28; L31, L32) to the assigned detector regions (D; I1 - I6; I10, I11, I20, I21; R1 - R8), the anti-reflection layer (63) is connected to the thin, strip-shaped layers (61) of the second conductivity type.

3. Scanning unit according to claim 1 or 2, **characterised in that** the detector regions (D; I1 - I6; I10, I11, 120, I21; R1 - R8) are disposed periodically to each other, a plurality of adjacent detector regions forming a group (I1 - I6; I10, I11, I20, I21; R1 - R8), which delivers mutually phase-shifted scanning signals, and **in that** respectively one strip conductor (L; L1 - L8; L11- L28; L31, L32) is connected to the detector regions (D; I1 - I6; I10, I11, I20, I21; R1 - R8) of the different groups which emit in-phase scanning signals.

4. Scanning unit according to claim 3, **characterised in that** four active detector regions form one group (I1 - I6; I10, I11, I20, I21), which delivers four scanning signals which are phase-shifted respectively by 90°, **in that** at least two groups of active detector regions (I1 - I6; I10, I11, I20, I21) are disposed next to each other in the measuring direction (x), and **in that** four parallel strip conductors (L1 - L8; L11 - L28) are connected to the detector regions of the groups (I1 - I6; I10, I11, I20, I21) which emit in-phase scanning signals.

5. Scanning unit according to claim 3 or 4, **characterised in that** a plurality of groups of active detector regions (I1 - I6; I10, I11, I20, I21) are disposed one behind the other and next to each other in the measuring direction (x), **in that** a number of strip conductors (L1 - L8; L11 - L28), which corresponds to the phase shift, is connected to the detector regions of the groups (I1 - 16; I10, I11, I20, I21) which are disposed one behind the other in the measuring direction (x) and deliver in-phase scanning signals, and **in that** the strip conductors (L1 - L8; L11 - L28), which detect in-phase scanning signals, of the groups (I1 - I6; I10, I11, 120, I21), which are disposed parallel to each other in the measuring direction (x), are connected to each other.

6. Scanning unit according to claim 5, **characterised in that** the connection of the strip conductors (L1 - L8; L11 - L28), which detect in-phase scanning signals, of the groups (I1 - 16; I10, I11, I20, I21), which are disposed parallel to each other in the measuring direction (x), is disposed on the rear side of the structured photodetector (6).

7. Scanning unit according to at least one of the preceding claims, **characterised in that** the structured photodetector (6) has a plurality of groups (D; I1 - I6; I10, I11, I20, I21; R1 - R8), which are disposed one behind the other in the measuring direction (x) and have respectively a plurality of detector regions (D), the one part of the groups having reference pulse detector regions (R1 - R8) for generating reference pulse signals and the other part of the groups having incremental signal detector regions (I1 - I6; I10, I11, I20, I21) for generating incremental signals, and **in that** the reference pulse detector regions (R1 - R8) are connected to reference pulse strip conductors (L31, L32) and the incremental signal detector regions (I1 - I6; I10, I11, I20, I21), which deliver in-phase output signals, are connected to respectively one incremental signal strip conductor (L1 - L8; L11 - L28).

8. Scanning unit according to claim 7, **characterised in that** at least the incremental signal strip conductors (L1 - L8; L11 - L28) are guided over the radiation-sensitive surfaces of the incremental signal detector regions (I1 - I6; I10, I11, I20, I21) and are connected respectively to incremental signal detector regions (I1 - I6; I10, I11, I20, I21) which deliver in-phase output signals.

9. Scanning unit according to claim 7 or 8, **characterised in that** there is provided two groups of incremental signal detector regions (I10, I11, I20, I21) with respectively two groups, disposed respectively one behind the other and next to each other in the measuring direction (x), of detector regions (I20, I11 or I20, I21), which deliver in-phase output signals, and, between the two groups of incremental signal detector regions (I10, I11, I20, I21), a group of reference pulse detector regions (R1 - R8), and **in that** the incremental signal strip conductors (L11 - L28) are guided respectively to the end-sides of the structured photodetector (6).

10. Scanning unit according to claim 9, **characterised in that** the reference pulse strip conductors (R1 - R8) are guided between the groups of incremental signal detector regions (I10, I11, I20, I21) which are disposed next to each other in the measuring direction.

11. Scanning unit according to claim 10, **characterised in that** the reference pulse strip conductor (L31), which detects the clock signals of the reference pulse detector regions (R1 - R8), is guided to the one end-side between the groups of incremental signal detector regions (I10, I11) of this side, which are disposed next to each other in the measuring direction (x), and the reference pulse strip conductor (L32), which detects the push-pull signals of the reference pulse detector regions (R1 - R8), is guided to the other end-side between the groups of incremental signal detector regions (I20, I21) of this side, which are disposed next to each other in the measuring direction (x).

12. Scanning unit according to claim 10, **characterised in that** the reference pulse strip conductors (L31, L32), which detect the clock signals and the push-pull signals of the reference pulse detector regions (R1 - R8), which are disposed in portions one above the other, are guided between the groups of incremental signal detector regions (I10, I11 or I20, I21) of the one or other side, which regions are disposed next to each other in the measuring direction (x).

13. Scanning unit according to claim 9 or 10, **characterised in that** the reference pulse strip conductors (L31, L32) are guided at least partially over the mutually oppositely situated lateral edges (6a, 6b) of the groups of incremental signal detector regions (I10, I11, I20, I21 ), which are disposed next to each other in the measuring direction (x).

14. Scanning unit according to at least one of the preceding claims 9 to 11, **characterised in that** the groups of incremental signal detector regions (I10, I11, I20 I21), which are situated respectively one behind the other in the measuring direction (x), are connected respectively to an incremental signal strip conductor (L11 - L28) for in-phase output signals, and **in that** the incremental signal strip conductors (L11 - L28) are guided over the reference pulse detector regions (R1 - R8).

## Revendications

1. Unité de palpage pour un dispositif optique de mesure de position avec un photodétecteur (6) optoélectronique structuré, qui comporte, disposées à proximité les unes des autres sur un substrat semiconducteur (60) commun avec un premier type de conductivité, plusieurs zones de détecteur (D ; I1-I6 ; I10, I11, 120, I21 ; R1-R8) formées de bandes étroites, de forme rectangulaire ou en forme de segment de cercle, sensibles à la lumière avec un deuxième type de conductivité (61), dont les grands côtés sont disposés à côté les uns des autres essentiellement perpendiculairement à la direction de mesure (x), et qui sont reliées à un dispositif de traitement par des pistes conductrices (L ; L1-L8 ; L11-L28 ; L31, L32) disposées essentiellement perpendiculairement aux grands côtés des zones de détecteur (D ; I1-I6 ; I10, I11, I20, I21 ; R1-R8), ainsi qu'une couche anti-réflexion (63) qui constitue la face avant du photodétecteur (6) et une couche isolante (62) disposée entre deux,
**caractérisée par le fait**
**qu'**au moins une partie des pistes conductrices (L ; L1-L8 ; L11-L28 ; L31, L32) passe au-dessus de la surface de plusieurs zones de détecteur (D ; I1-I6 ; I10, I11, I20, I21 ; R1-R8) et sont reliées aux zones de détecteur (D ; I1-I6; I10, I11, I20, I21 ; R1-R8) associées et par le fait que des ouvertures sont prévues dans la couche anti-réflexion (63) au niveau des liaisons entre les pistes conductrices (L ; L1-L8 ; L11-L28 ; L31, L32) les zones de détecteur (D ; I1-I6 ; I10, I11, 120, I21 ; R1-R8) associées.

2. Unité de palpage pour un dispositif optique de mesure de position avec un photodétecteur (6) optoélectronique structuré, qui comporte, disposées à proximité les unes des autres sur un substrat semiconducteur (60) commun avec un premier type de conductivité, plusieurs zones de détecteur (D ; I1-I6 ; I10, I11, I20, I21 ; R1-R8) formées de bandes étroites, de forme rectangulaire ou en forme de segment de cercle, sensibles à la lumière avec un deuxième type de conductivité (61), dont les grands côtés sont disposés à côté les uns des autres essentiellement perpendiculairement à la direction de mesure (x), et qui sont reliées à un dispositif de traitement par des pistes conductrices (L ; L1-L8 ; L 1-L28 ; L31, L32) disposées essentiellement perpendiculairement aux grands côtés des zones de détecteur (D ; I1-I6 ; I10, I11, I20, I21 ; R1-R8), ainsi qu'une couche anti-réflexion (63) qui constitue la face avant du photodétecteur (6) et une couche isolante (62) disposée entre deux,
**caractérisée par le fait**
**qu'**au moins une partie des pistes conductrices (L ; L1-L8 ; L11-L28 ; L31, L32) passe au-dessus de la surface de plusieurs zones de détecteur (D ; I1-I6 ; I10, I11, I20, I21 ; R1-R8) et sont reliées aux zones de détecteur (D ; I1-I6 ; I10, I11, I20, I21 ; R1-R8) associées et par le fait qu'au niveau des liaisons entre les pistes conductrices (L ; L1-L8 ; L11-L28 ; L31, L32) les zones de détecteur (D ; I1-I6 ; I10, I11, I20, I21 ; R1-R8) associées, la couche anti-réflexion (63) est reliée aux fines couches (61), en forme de bandes, du deuxième type de conductivité.

3. Unité de palpage selon la revendication 1 ou 2, **caractérisée par le fait que** les zones de détecteur (D ; I1-I6 ; I10, I11, I20, I21 ; R1-R8) sont disposées de manière périodique entre elles, plusieurs zones de détecteur voisines formant un groupe (I1-I6 ; I10, I11, I20, I21 ; R1-R8) qui délivre des signaux de palpage mutuellement déphasés, et **par le fait que** chaque fois une piste conductrice (L ; L1-L8 ; L11-L28 ; L31, L32) est reliée aux zones de détecteur (D ; I1-I6 ; I10, I11, I20, I21 ; R1-R8) des différents groupes qui délivrent des signaux de palpage de même phase.

4. Unité de palpage selon la revendication 3, **caractérisée par le fait que** quatre zones de détecteur actives forment un groupe (I1-I6 ; I10, I11, I20, I21 ; R1-R8) qui délivre quatre signaux de palpage déphasés chaque fois de 90°, qu'au moins deux groupes de zones de détecteur actives (D ; I1-I6 ; I10, I11, I20, I21 ; R1-R8) sont disposés l'un à côté de l'autre dans la direction de mesure (x) et que quatre pistes conductrices (L1-L8 ; L11-L28) parallèles sont reliées aux zones de détecteurs des groupes (I1-I6 ; I10, I11, I20, I21) qui délivrent des signaux de palpage de même phase.

5. Unité de palpage selon la revendication 3 ou 4, **caractérisée par le fait que** plusieurs groupes (I1-I6; I10, I11, I20, I21) de zones de détecteur sont disposés l'un derrière l'autre et l'un à côté de l'autre dans la direction de mesure (x), **par le fait que** des pistes conductrices (L1-L8 ; L11-L28) en un nombre qui correspond au déphasage sont reliées aux zones de détecteur des groupes (I1-I6 ; I10, I11, I20, I21) disposés l'un derrière l'autre qui délivrent des signaux de palpage de même phase et **par le fait que** les pistes conductrices (L1-L8 ; L11-L28) qui détectent des signaux de palpage de même phase des groupes (I1-I6 ; I10, I11, I20, I21) disposés parallèlement les uns aux autres dans la direction de mesure (x) sont reliées entre elles.

6. Unité de palpage selon la revendication 5, **caractérisée par le fait que** la liaison des pistes conductrices (L1-L8 ; L11-L28) qui détectent des signaux de palpage de même phase des groupes (I1-I6 ; I10, I11, I20, I21) disposés parallèlement les uns aux autres dans la direction de mesure (x) est disposée sur la face arrière du photodétecteur (6) structuré.

7. Unité de palpage selon au moins une des revendications précédentes, **caractérisée par le fait que** le photodétecteur (6) structuré, dans la direction de mesure (x), présente plusieurs groupes (D ; I1-I6 ; I10, I11, I20, I21 ; R1-R8) disposés les uns à la suite des autres, avec chaque fois plusieurs zones de détecteur (D), une partie des groupes comprenant des zones de détecteur d'impulsion de référence (R1-R8) pour produire des signaux d'impulsions de référence et l'autre partie des groupes comprenant des zones de détecteur de signal incrémental (I1-I6 ; I10, I11, I20, I21) pour produire des signaux incrémentaux, et **par le fait que** les zones de détecteur d'impulsion de référence (R1-R8) sont reliées à des pistes conductrices (L31, L32) d'impulsion de référence et les zones de détecteur de signal incrémental (I1-I16 ; I10, I11, I20, I21) qui délivrent des signaux de sortie de même phase sont reliées chaque fois à une piste conductrice de signal incrémental (L1-L8 ; L21-L28).

8. Unité de palpage selon la revendication 7, **caractérisée par le fait qu'**au moins les pistes conductrices de signal incrémental (L1-L8 ; L21-L28) passent au-dessus des surfaces sensibles au rayonnement des zones de détecteur de signal incrémental (I1-I6 ; I10, I11, I20, I21) et sont reliées chaque fois à des zones de détecteur de signal incrémental (I1-I6 ; I10, I11, I20, I21) qui délivrent des signaux de sortie de même phase.

9. Unité de palpage selon la revendication 7 ou 8, **caractérisée par le fait qu'**il est prévu deux groupes de zones de détecteur de signal incrémental (I10, I11, I20, I21) avec chaque fois deux groupes disposés l'un derrière l'autre et l'un à côté de l'autre dans la direction de mesure (x) de zones de détecteur (I10, I11 et I20, I21) qui délivrent des signaux de sortie de même phase, et un groupe de zones de détecteur d'impulsion de référence (R1-R8) disposé entre les deux groupes de zones de détecteur de signal incrémental (I10, I11, I20, I21), et **par le fait que** les pistes conductrices de signal incrémental (L21-L28) sont amenées chaque fois jusqu'aux faces frontales du photodétecteur (6) structuré.

10. Unité de palpage selon la revendication 9, **caractérisée par le fait que** les pistes conductrices d'impulsion de référence (R1-R8) passent entre les zones de détecteur de signal incrémental (I10, I11, I20, I21) disposées les unes à côté des autres.

11. Unité de palpage selon la revendication 10, **caractérisée par le fait que** la piste conductrice d'impulsion de référence (L31) qui détecte les signaux de synchronisation des zones de détecteur d'impulsion de référence (R1-R8) est amenée à une face frontale entre les groupes de zones de détecteur de signal incrémental (I10, I11) disposés de ce côté les uns à côté des autres dans la direction de mesure (x) et la piste conductrice d'impulsion de référence (L32) qui détecte les signaux symétriques des zones de détecteur d'impulsion de référence (R1-R8) est amenée à l'autre face frontale entre les groupes de zones de détecteur de signal incrémental (I20, I21) disposés de ce côté les uns à côté des autres dans la direction de mesure (x).

12. Unité de palpage selon la revendication 10, **caractérisée par le fait que** les pistes conductrices d'impulsion de référence (L31, L32) qui détectent les signaux de synchronisation et les signaux symétriques des zones de détecteur d'impulsion de référence (R1-R8) par endroits sont disposées les unes au-dessus des autres entre les groupes de zones de détecteur de signal incrémental (I10, I11 et I20, I21) disposés les uns à côté des autres dans la direction de mesure (x), d'un côté ou de l'autre.

13. Unité de palpage selon la revendication 9 ou 10, **caractérisée par le fait que** les pistes conductrices d' impulsion de référence (L31, L32), au moins partiellement, passent au-dessus des bords latéraux (6a, 6b) en vis-à-vis des groupes de zones de détecteur de signal incrémental (I10, I11 et I20, I21) disposés les uns à côté des autres dans la direction de mesure (x).

14. Unité de palpage selon au moins une des revendications précédentes 9 à 11, **caractérisée par le fait que** les groupes de zones de détecteur de signal incrémental (I10, I11 et I20, I21) disposés les uns à la suite des autres dans la direction de mesure (x) sont reliés chaque fois à une piste conductrice de signal incrémental (L11-L28) pour des signaux de sortie de même phase et que les pistes conductrices de signal incrémental (L11-L28) passent au-dessus des zones de détecteur d'impulsion de référence (R1-R8).
